## Europäisches Patentamt
## European Patent Office
## Office européen des brevets

(11) Publication number: **0 119 711**
**B1**

(12) **EUROPEAN PATENT SPECIFICATION**

(45) Date of publication of patent specification: **29.07.87**

(51) Int. Cl.⁴: $G\ 01\ R\ 25/00$, $G\ 01\ R\ 35/00$

(21) Application number: **84300795.6**

(22) Date of filing: **08.02.84**

(54) Lock-in amplifiers.

(30) Priority: **18.02.83 GB 8304618**

(43) Date of publication of application:
**26.09.84 Bulletin 84/39**

(45) Publication of the grant of the patent:
**29.07.87 Bulletin 87/31**

(84) Designated Contracting States:
**DE FR GB NL**

(56) References cited:
**US-A-4 337 517**

**Patent Abstracts of Japan, vol. 4, no. 103, 23 July 1980, page 24P20**

**Patent Abstracts of Japan, vol. 4, no. 153, 25 October 1980, page 166P33**

**JOURNAL OF PHYSICS E. SCIENTIFIC INSTRUMENTS, vol. 16, no. 4, April 1983, Dorking G.J., GERRITSMA et al. "An on-line digital phase sensitive detector in the range 2 mHz-2 kHz", pages 270-277**

(73) Proprietor: **PRINCETON APPLIED RESEARCH CORPORATION**
**7 Roszel Road**
**Princeton New Jersey 08540 (US)**

(72) Inventor: **Faulkner, Eric Andrew**
**Home Close Bradcutts Lane**
**Cookham Berkshire (GB)**

(74) Representative: **Livsey, Gilbert Charlesworth Norris**
**HYDE, HEIDE & O'DONNELL 146 Buckingham Palace Road**
**London SW1W 9TR (GB)**

(56) References cited:
**WESCON CONFERENCE RECORD, vol. 25, September 1981, El Segundo, R. TALAMBIRAS "Sampling network analyzer for periodic functions", pages 1-7 (7/2)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Background of the Invention

The lock-in amplifier is a measuring instrument having two input voltages, commonly known as the signal input and the reference input, and one output which is either in the form of an analog voltage or in the form of a digital word.

The essential part of the processing done by a lock-in amplifier is the combination of a voltage derived from the signal input with a voltage derived from the reference input in a unit commonly known as a phase-sensitive rectifier or a demodulator but having the essential function of a special-purpose analog multiplier followed by a low-pass filter. Under suitable conditions this operation may result in the accurate measurement of a signal, accompanied by noise of enormously greater amplitude than that of the signal itself.

It is an object of the invention to provide a lock-in amplifier which provides an output signal of improved accuracy.

Summary of the Invention

According to the invention a lock-in amplifier includes a phase-sensitive detector having a signal input and a reference input, adding means for adding a dc offset correction signal to the output of the phase-sensitive detector, control means for providing such correction signal to the said adding means, the control means having an input derived from the reference input to the phase-sensitive detector so that the magnitude of the dc offset correction signal depends on the frequency of the reference input.

Preferably an ambient temperature measuring device is provided the output of which is applied to the said control means so that the magnitude of the dc offset signal also depends on the ambient temperature.

Preferably also a compensation signal is added to the output of the phase-sensitive detector to compensate for frequency dependent and temperature dependent changes in the level of the output of the phase-sensitive detector.

In a preferred embodiment the control means is a digital controller which provides a digital signal to the added means representing the magnitude of the dc offset signal and a digital signal to the further adding means representing the magnitude of the compensation signal.

Output filter means may be provided through which the output of the phase-sensitive detector is passed, the output filter having a zero response at the frequency of the reference input and at harmonic frequencies thereof.

Input filter means may also be provided through which the signal input to the phase-sensitive detector is passed, the input filter means having zero response at the frequency of the input and harmonics thereof.

To compensate for any frequency dependent phase shifts through the circuit a voltage-controlled phase shifter may be provided through which the reference input to the phase-sensitive detector is passed. The control voltage for the phase shifter is supplied from the control means.

Brief Description of the Drawings

In order that the invention may be more fully understood reference will now be made to the accompanying drawings in which:

Figure 1 illustrates in block diagrammatic form a lock-in amplifier embodying the invention, and

Figure 2 illustrates in a more detailed form the final switching filter of Figure 1.

Description of the Preferred Embodiment

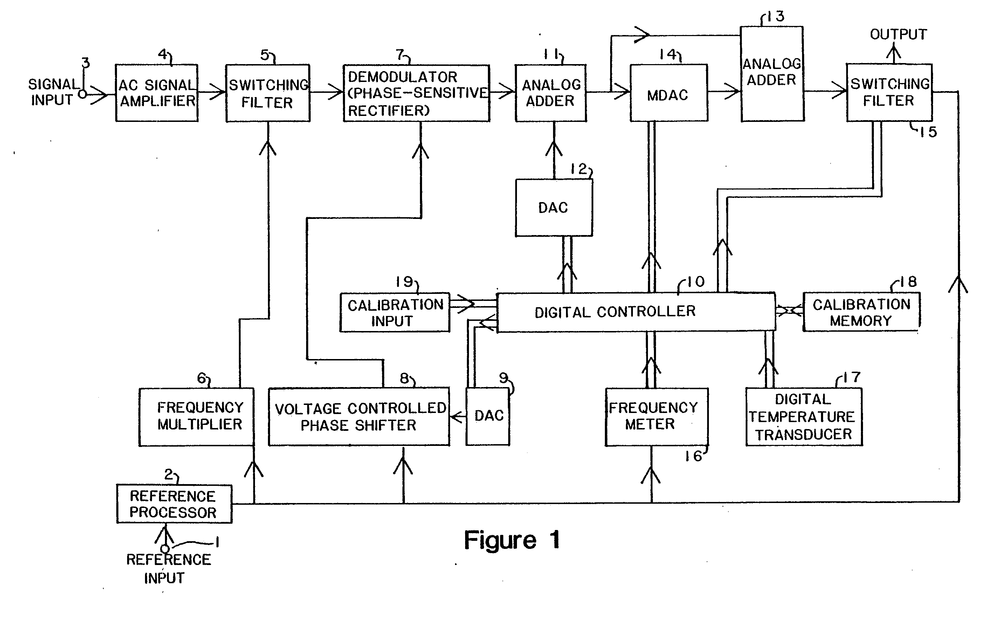

In the circuit shown in Figure 1, the reference input at an input terminal 1 is shown as being processed by a reference processor 2 which modifies the waveform into a convenient form (usually a square-wave) and also provides any required phase-shift under manual or computer control. The design of reference processor 2 is well known and will not be discussed here. The output of reference processor 2, which will be referred to as the reference voltage, is connected to several units which will be described below.

The phrase "reference frequency" will be used to mean the fundamental Fourier component of the reference voltage, which is assumed to be periodic.

Considering now the signal path, the signal input at a signal input terminal 3 is amplified by an ac signal amplifier 4 of variable gain, which may incorporate filters, and then filtered by an input switching filter 5. This filter 5 is an analog filter of the class in which the resonance frequency is equal to a very good approximation to some submultiple (typically 1/50) of the frequency of a switching input. An example of a filter of this class is the well-known switched-capacitor filter. In the present circuit the switching input to switching filter 5 is derived from the reference voltage by means of a frequency multiplier 6 having a multiplication factor (typically 50) equal to the inverse of the submultiple which characterises switching filter 5. The frequency multiplier 6 is typically based on a phase-lock loop. The result of this arrangement is that switching filter 5 is tuned to a frequency which is very close to the reference frequency. The functions of switching filter 5 are to prevent the circuit from responding to components in the signal input which are at or near harmonics of the reference frequency, and also to increase the dynamic range of the circuit.

The output from switching filter 5 is connected to one of the inputs of the demodulator or phase-sensitive rectifier 7, the other input being derived from the reference processor 2 via a voltage-controlled phase shifter 8. The controlling voltage for voltage-controlled phase shifter 8 is derived from a digital-to-analog converter (DAC) 9 the digital input to which is derived from a digital controller 10. Digital controller 10 has a number of other functions which will be described below. The primary purpose of phase shifter 8 is to cancel the effects of frequency-dependent phase shifts resulting from the imperfect operation of switching filter 5.

The demodulator 7 contains a low-pass filter and if necessary a dc amplifier, and its output is processed in sequence by the following three units:

(a) analog adder 11 by means of which a dc level is added to the demodulator output. This level is derived from a DAC 12 the digital input to which is derived from the digital controller 10. The purpose of this arrangement is to cancel the effects of frequency-dependent and temperature-dependent offsets generated in the demodulator 7.

(b) analog adder 13 in conjunction with multiplying digital-to-analog converter (MDAC) 14 the digital input to MDAC 14 being derived from digital controller 10. The purpose of this arrangement is to cancel the effects of frequency-dependent and temperature-dependent changes in the gain of the other components of the system.

(c) switching filter 15, an analog filter the characteristics of which are controlled by a switching input derived from reference processor 2 and also by a digital input derived from digital controller 10. The output of switching filter 15 is the analog output from the circuit, which although shown in Figure 1 as the sole output is of such a nature as to be readily convertible into digital form by a suitable analog-to-digital converter.

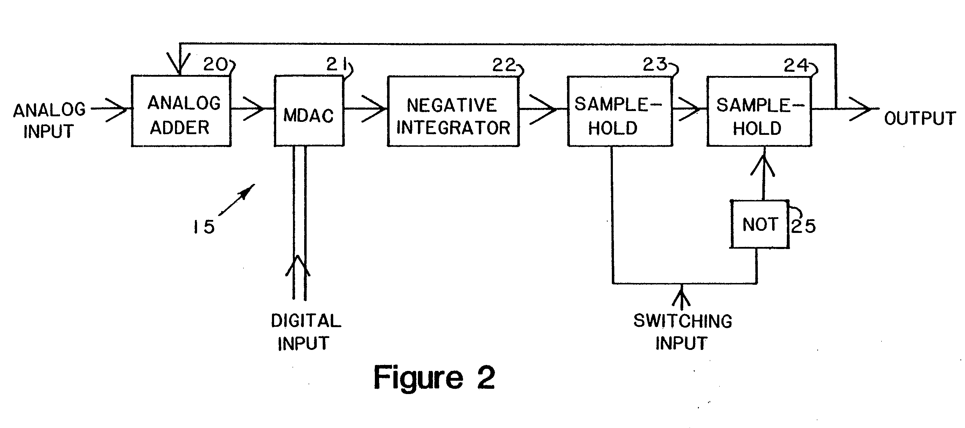

The purpose of switching filter 15 is to prevent the system output from containing ac components at the reference frequency and/or its harmonics. It is shown in greater detail in Figure 2. It consists of an analog adder 20, MDAC 21, a negative integrator 22 (i.e. a unit with transfer function equal to a negative constant multiplied by 1/s), and two sample-hold units 23 and 24 with a NOT gate 25 between their enable inputs, the interconnections being as shown in Figure 2. It can be proved that this arrangement consists of a time-varying linear system with a frequency-response function having zeros at the fundamental frequency of the switching input (assumed periodic) and all its harmonics, and with a dynamic response determined for any given switching frequency by the digital input to MDAC 21. In use, a digital word appropriate to the particular reference frequency in use is supplied by digital controller 10 to MDAC 21.

The special advantages of the circuit described above are based on the action of the digital controller 10 (which at the present time would normally be implemented with a microprocessor) and its associated frequency meter 16, temperature transducer 17 and calibration memory 18. Whenever the instrument is in use, the temperature transducer 17 and frequency meter 16 supply digital inputs to controller 10, and these inform the controller of the current values of temperature and reference frequency. On the basis of these inputs, controller 10 selects from the calibration memory 18 suitable digital words to be latched into DAC 12, DAC 9 and MDAC 14 to cancel the effects of offset errors, phase errors and gain errors respectively. The controller also supplies a suitable frequency-dependent word to MDAC 21 to optimize the dynamic response of switching filter 15.

The calibration memory 18 is supplied with its contents by the following calibration procedure. Before the instrument is first used, and at suitable intervals thereafter, the instrument is connected to a computer-controlled calibration system (not shown in the diagrams) which is able to supply signal and reference inputs of any required frequency and phase, to vary the temperature of the instrument over the specified operating range, and to accept a measure of the output in digital form. On the basis of the measured output values for various values of input frequency and phase and of temperature, it is a relatively simple matter for the calibration system to compute appropriate digital words and present them to a calibration input 19 of the controller for storage in calibration memory 18. The calibration memory 18 is of such a design as to be able to retain its contents when the power supply to the instrument is switched off.

## Claims

1. A lock-in amplifier including a phase-sensitive detector (7) having a signal input (3) and a reference input (1), adding means (11) for adding a dc offset correction signal to the output of the phase-sensitive detector (7), control means (10) for providing such correction signal to the said adding means (11), the control means (10) having an input derived from the reference input (1) to the phase-sensitive detector (7) so that the magnitude of the dc offset correction signal depends on the frequency of the reference input (1).

2. The amplifier as claimed in Claim 1 in which an ambient temperature measuring device (17) is provided the output of which is applied to the said control means (10) so that the magnitude of the dc offset signal also depends on the ambient temperature.

3. The amplifier as claimed in Claim 1 or Claim 2 in which the said control means (10) is arranged to provide a digital signal representing the magnitude of the dc offset correction signal and digital-to-analog conversion means (12) are provided for converting said digital signal to an analog signal.

4. The amplifier as claimed in Claim 2 in which further adding means (13) are provided for adding a compensation signal to the output of the phase-sensitive detector (7) the said control means (10) providing the compensation signal, which signal is derived from the reference input (1) and the output of the ambient temperature measuring device (17) so that the output of the further adding means (13) is compensated for frequency dependent and temperature dependent changes in the level of the output of the phase-sensitive detector (7).

5. The amplifier as claimed in Claim 4 in which said control means (10) is arranged to provide a digital signal representing the said compensation signal to a multiplying digital-to-analog converter (14) together with a further input being the output of the said adding means (11), and wherein the output of the said multiplying digital-to-analog converter (14) is supplied to the further adding means (13).

6. The amplifier as claimed in any one of the preceding claims in which output filter means (15) are provided through which the output of the phase-sensitive detector (7) is passed, said output filter means (15) having a zero response at the frequency of the reference input (1) and harmonics thereof.

7. The amplifier as claimed in any one of the preceding claims in which input filter means (5) are provided through which the signal input (3) to the phase-sensitive detector (7) is passed, said input filter means (5) having zero response at the frequency of the reference input (1) and harmonics thereof.

8. The amplifier as claimed in any one of the preceding claims in which the reference input (1) to the phase-sensitive detector (7) is passed through a voltage controlled phase shifter (8), the control voltage to which is supplied from said control means (10) whereby to compensate for any frequency dependent phase shifts in the circuit.

**Patentansprüche**

1. Ein synchronisierter Verstärker, umfassend einen phasenempfindlichen Demodulator (7) mit einem Signaleingang (3) und einem Referenzeingang (1), Summationsmitteln (11) zum Addieren eines Gleichstromabweichungs-Korrektursignals zum Ausgang des phasenempfindlichen Demodulators (7), Steuermitteln (10) zur Lieferung eines solchen Korrektursignals zu den Summationsmitteln (11), wobei die Steuermittel (10) einen vom Referenzeingang (1) zum phasenempfindlichen Demodulator (7) abgeleiteten Eingang aufweisen, so daß die Größe des Gleichstromabweichungs-Korrektursignals von der Frequenz des Referenzeingangs (1) abhängt.

2. Der Verstärker wie beansprucht in Anspruch 1, bei welchem eine Raumtemperatur-Meßvorrichtung (17) vorgesehen ist, deren Ausgang den besagten Steuermitteln (10) zugeführt wird, so daß die Größe des Gleichstromabweichungs-Signals auch von der Raumtemperatur abhängt.

3. Der Verstärker wie beansprucht in Anspruch 1 oder Anspruch 2, bei welchem die besagten Steuermittel (10) ausgelegt sind zur Lieferung eines die Größe des Gleichstromabweichungs-Korrektursignals darstellenden Digitalsignals und Digital-Analog-Wandlermittel (12) zum Umwandeln des besagten Digitalsignals in ein Analogsignal vorgesehen sind.

4. Der Verstärker wie beansprucht in Anspruch 2, bei welchem weitere Summationsmittel (13) zum Addieren eines Kompensationssignals zum Ausgang des phasenempfindlichen Demodulators (7) vorgesehen sind, die besagten Steuermittel (10) das Kompensationssignal liefern, welches Signal vom Referenzeingang (1) und dem Ausgang der Raumtemperatur-Meßvorrichtung (17) abgeleitet ist, so daß der Ausgang der weiteren Summationsmittel (13) kompensiert ist gegen frequenzabhängige und temperaturabhängige Veränderungen im Pegel des Ausgangs des phasenempfindlichen Demodulators (7).

5. Der Verstärker wie beansprucht in Anspruch 4, bei welchem die besagten Steuermittel (10) ausgelegt sind zur Lieferung eines das Kompensationssignal darstellenden Digitalsignals an einen Multiplikations-Digital-Analog-Wandler (14) zusammen mit einem weiteren Eingang, welcher der Ausgang der besagten Summationsmittel (11) ist, und wobei der Ausgang des besagten Multiplikations-Digital-Analog-Wandlers (14) den weiteren Summationsmitteln (13) zugeführt wird.

6. Der Verstärker wie beansprucht in irgendeinem der vorhergehenden Ansprüche, bei welchem Ausgangs-Filtermittel (15) vorgesehen sind, durch welche der Ausgang des phasenempfindlichen Demodulators (7) hindurchgeht, wobei die besagten Ausgangs-Filtermittel (15) bei der Frequenz des Referenzeingangs (1) und deren Oberschwingungen eine Nullansprache aufweisen.

7. Der Verstärker wie beansprucht in irgendeinem der vorhergehenden Ansprüche, bei welchem Eingangs-Filtermittel (5) vorgesehen sind, durch welche der Signaleingang (3) zum phasenempfindlichen Demodulator (7) hindurchgeht, wobei diese Eingangs-Filtermittel (5) bei der Frequenz des Referenzeingangs (1) und deren Oberschwingungen eine Nullansprache aufweisen.

8. Der Verstärker wie beansprucht in irgendeinem der vorhergehenden Ansprüche, bei welchem der Referenzeingang (1) zum phasenempfindlichen Demodulator (7) durch einen spannungsgeregelten Phasenverschieber (8) hindurchgeht, zu welchem die Regelspannung von den besagten Steuermitteln (10) zugeführt wird, um dadurch jedwede frequenzabhängige Phasenverschiebungen im Stromkreis zu kompensieren.

**Revendications**

1. Un amplificateur à verrouillage comprenant un détecteur sensible à la phase (7) recevant une information d'entrée de signal (3) et une information d'entrée de référence (1), des moyens d'addition (11) destinés à additionner un signal de correction de décalage continu au signal de sortie du détecteur sensible à la phase (7), des moyens de commande (10) destinés à appliquer ce signal de correction aux moyens d'addition (11), les moyens de commande (10) recevant un signal d'entrée obtenu à partir de l'information d'entrée de référence (11) qui est appliquée au détecteur sensible à la phase (7), de façon que la valeur du signal de correction de décalage continu dépende de la fréquence de l'information d'entrée de référence (1).

2. L'amplificateur selon la revendication 1, dans lequel il existe un dispositif de mesure de la température ambiante (17) dont le signal de sortie est appliqué aux moyens de commande (10), de façon que la valeur du signal de décalage continu dépende également de la température ambiante.

3. L'amplificateur selon la revendication 1 ou la revendication 2, dans lequel les moyens de commande (10) sont conçus de façon à produire un signal numérique représentant la valeur du signal de correction de décalage continu, et des moyens de conversion numérique-analogique (12) sont prévus pour convertir ce signal numérique en un signal analogique.

4. L'amplificateur selon la revendication 2, dans lequel il existe des moyens d'addition supplémentaires (13) destinés à additionner un signal de compensation au signal de sortie du détecteur sensible à la phase (7), le signal de compensation étant produit par les moyens de commande (10), et obtenu à partir de l'information d'entrée de référence (1) et du signal de sortie du dispositif de mesure de la température ambiante (17), de façon que le signal de sortie des moyens d'addition supplémentaires (13) soit compensé vis-à-vis des variations dépendant de la fréquence et dépendant de la température qui se manifestent dans le niveau du signal de sortie du détecteur sensible à la phase (7).

5. L'amplificateur selon la revendication 4, dans lequel les moyens de commande (10) sont conçus de façon à appliquer le signal numérique représentant le signal de compensation à un convertisseur numérique-analogique multiplicateur (14) qui reçoit également un autre signal d'entrée qui est le signal de sortie des moyens d'addition (11), et dans lequel le signal de sortie du convertisseur numérique-analogique multiplicateur (14) est appliqué aux moyens d'addition supplémentaires (13).

6. L'amplificateur selon l'une quelconque des revendications précédentes, dans lequel il existe un filtre de sortie (15) dans lequel on fait passer le signal de sortie du détecteur sensible à la phase (7), ce filtre de sortie ayant une réponse nulle à la fréquence de l'information d'entrée de référence (1) et à ses harmoniques.

7. L'amplificateur selon l'une quelconque des revendications précédentes, dans lequel il existe un filtre d'entrée (5) par lequel on fait passer l'information d'entrée de signal (3) qui est appliquée au détecteur sensible à la phase (7), ce filtre d'entrée (5) ayant une réponse nulle à la fréquence de l'information d'entrée de référence (1) et à ses harmoniques.

8. L'amplificateur selon l'une quelconque des revendications précédentes, dans lequel on fait passer l'information d'entrée de référence (1) appliquée au détecteur sensible à la phase (7), dans un déphaseur commande par tension (8), dont la tension de commande est fournie par les moyens de commande (10), pour compenser ainsi tous les déphasages dépendant de la fréquence qui se produisent dans le circuit.

Figure 1

Figure 2

ANALOG INPUT → **ANALOG ADDER** (20) → **MDAC** (21) → **NEGATIVE INTEGRATOR** (22) → **SAMPLE-HOLD** (23) → **SAMPLE-HOLD** (24) → OUTPUT

15

DIGITAL INPUT

SWITCHING INPUT

NOT (25)

0 119 711

2